# EUROPEAN PATENT APPLICATION

(11) **EP 2 325 854 A2**
(43) Date of publication of application: **25.05.2011**
(21) Application number: 10168300.1
(22) Date of filing: 02.07.2010
(51) Int. Cl.: H01G 9/20

(54) **Photoelectric device**

(30) Priority: 19.11.2009 KR 20090112200
(71) Applicant: Samsung SDI Co., Ltd., Gyeonggi-do (KR)
(72) Inventor: Chang, Yi-Hyun, Gyeonggi-do (KR); Lee, Seung-Hwan, Gyeonggi-do (KR); Lim, Jae-Seok, Gyeonggi-do (KR)
(74) Representative: Walaski, Jan Filip

(57) **Abstract**

A photoelectric device capable of increasing an adhesive force between substrates is provided. The photoelectric device includes a first and second substrates facing each other, a photoelectrode including a first transparent conductive layer and formed on a surface of the first substrate facing the second substrate, a counter electrode including a second transparent conductive layer and formed on a surface of the second substrate facing the first substrate, a semiconductor layer formed on the photoelectrode and including a photosensitive dye that generates electrons when excited by light, an electrolyte disposed between the semiconductor layer and the counter electrode, and a sealing member disposed between the first and second transparent conductive layers. At least one of the first and second transparent conductive layers has a first stepped portion in which the sealing member is disposed. The sealing member seals a space between the first and second transparent conductive layers. Accordingly, an adhesive force and a sealing force between the sealing member and the light receiving substrate may be increased.

## Description

The present invention relates to a photoelectric device capable of increasing an adhesive force between a substrate and a sealing member.

Extensive research has recently been conducted on photoelectric devices that convert light into electric energy. Among such devices, solar cells utilizing sunlight have attracted attention as alternative energy sources to fossil fuels.

As research on solar cells having various working principles has been continuously conducted, wafer-based crystalline silicon solar cells using a p-n semiconductor junction have appeared to be the most prevalent ones. However, the manufacturing costs of wafer-based crystalline silicon solar cells are high because they are formed of a high purity semiconductor material.

Unlike silicon solar cells, dye-sensitized solar cells include a photosensitive dye that receives visible light and generates excited electrons, a semiconductor material that receives the excited electrons, and an electrolyte that reacts with electrons returning from an external circuit. Since dye-sensitized solar cells have much higher photoelectric conversion efficiency than other conventional solar cells, the dye-sensitized solar cells are viewed as the next generation solar cells.

One or more embodiments of the present invention include a photoelectric device capable of increasing an adhesive force between a substrate and a sealing member by reducing the thickness of a transparent conductive layer contacting the sealing member or by carving the substrate.

Additional aspects will be set forth in part in the description which follows and, in part, will be apparent from the description, or may be learned by practice of the presented embodiments.

According to one or more embodiments of the present invention, a photoelectric device includes a first substrate, a second substrate facing the first substrate, a photoelectrode including a first transparent conductive layer and formed on a surface of the first substrate facing the second substrate, a counter electrode including a second transparent conductive layer and formed on a surface of the second substrate facing the first substrate, a semiconductor layer formed on the photoelectrode and including a photosensitive dye that generates electrons when excited by light, an electrolyte disposed between the semiconductor layer and the counter electrode, and a sealing member disposed between the first and second transparent conductive layers. At least one of the first and second transparent conductive layers has a first stepped portion. The sealing member seals a space between the first and second transparent conductive layers.

The first stepped portion may be formed by local heating using a laser or the like.

At least one of the first and second substrates may have a second stepped portion formed to a depth and with a width. The second stepped portion may be formed in an edge portion of the at least one of the first and second substrates.

The second stepped portion may have a depth that is less than 50 % of the thickness of the at least one of the first and second substrates.

The first stepped portion may be formed to a depth and with a width in an edge portion of the at least one of the first and second transparent conductive layers.

The depth of the first stepped portion may be less than 20 % of the thickness of the at least one of the first and second transparent conductive layers.

The depth of the first stepped portion may be 100 % of the thickness of the at least one of the first and second transparent conductive layers.

The first stepped portion may be formed to a depth and with a width in an edge portion of the second transparent conductive layer, and the first substrate may have a second stepped portion formed in an edge portion of the first substrate.

The depth of the second stepped portion may be less than 50 % of the thickness of the first substrate, or the depth of the first stepped portion may be less than 20 % of the thickness of the second transparent conductive layer.

The depth of the second stepped portion may be less than 50 % of the thickness of the first substrate, or the depth of the first stepped portion may be 100 % of the thickness of the second transparent conductive layer.

The first stepped portion may be formed to a depth and with a width in an edge portion of the first transparent conductive layer, and the second substrate may have a second stepped portion formed in an edge portion of the second substrate.

The depth of the second stepped portion may be less than 50 % of the thickness of the second substrate, or the depth of the first stepped portion may be less than 20 % of the thickness of the first transparent conductive layer.

The depth of the second stepped portion may be less than 50 % of the thickness of the second substrate, or the depth of the first stepped portion may be 100 % of the thickness of the first transparent conductive layer.

According to one or more embodiments of the present invention, a photoelectric device includes a first substrate having a stepped portion, a second substrate facing the first substrate and having a stepped portion, a photoelectrode formed on a surface of the first substrate facing the second substrate, a counter electrode formed on a surface of the second substrate facing the first substrate, a semiconductor layer formed on the photoelectrode and including a photosensitive dye that generates electrons when excited by light, an electrolyte disposed between the semiconductor layer and the counter electrode, and a sealing member disposed between the first substrate and the second substrate. The sealing member seals a space between the first substrate and the second substrate.

The stepped portions of the first and second substrates may be formed by local heating using a laser or the like.

The stepped portions of the first and second substrates may be formed to a depth and with a width, and may be formed in edge portions of the first and second substrates, respectively.

The depth of the stepped portion of the first substrate may be less than 50 % of the thickness of the first substrate.

Accordingly, an adhesive force and a sealing force between the sealing member and the substrate may be increased by changing the shape of a basic material under the sealing member.

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:
FIG. 1 is an exploded perspective view of a photoelectric device according to an embodiment of the present invention;
FIG. 2 is a cross-sectional view taken along a line II-II of FIG. 1, according to an embodiment of the present invention;
FIG. 3 is a cross-sectional view taken along the line II-II of FIG. 1, according to another embodiment of the present invention; and
FIG. 4 is a cross-sectional view taken along the line II-II of FIG. 1, according to another embodiment of the present invention.

Reference will now be made in detail to embodiments, examples of which are illustrated in the accompanying drawings. The following description and the attached drawings are provided for better understanding of the invention, and descriptions of techniques or structures related to the present invention which would be obvious to one of ordinary skill in the art will be omitted.

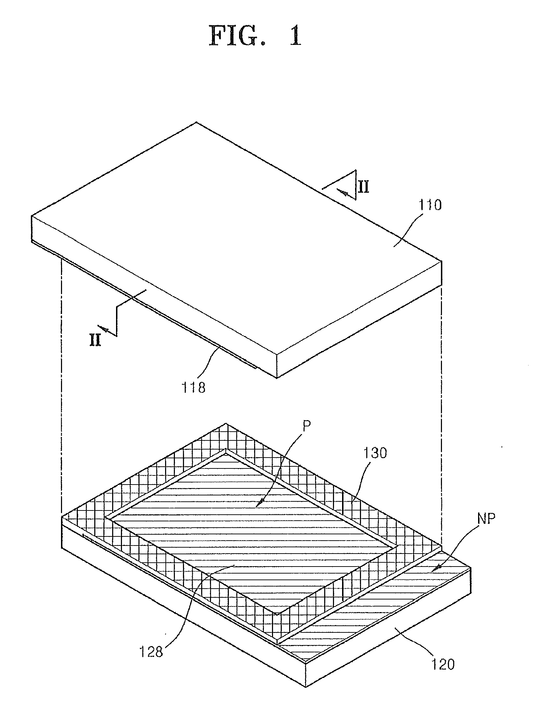

FIG. 1 is an exploded perspective view of a photoelectric device according to an embodiment of the present invention. Referring to FIG. 1, the photoelectric device includes a light receiving substrate (first substrate) 110 and a counter substrate (second substrate) 120 formed to face each other, and a sealing member 130 formed along edges of the light receiving substrate 110 and the counter substrate 120 to seal a space between the light receiving substrate 110 and the counter substrate 120. The light receiving substrate 110 includes a first function layer 118, and the counter substrate 120 includes a second function layer 128. Each of the first and second function layers 118 and 128 performs photoelectric conversion. The photoelectric device further includes an electrolyte (not shown) filled in the space between the first substrate 110 and the second substrate 120. The electrolyte is injected into the photoelectric device through an electrolyte inlet (not shown). The electrolyte is sealed by the sealing member 130, and thus the electrolyte is prevented from leaking out of the photoelectric device. The photoelectric device is divided into a photoelectric conversion area P and a peripheral area NP that is disposed at edge portion of the photoelectric device.

For example, the function layers 118 and 128 respectively formed on the light receiving substrate 110 and the counter substrate 120 include a semiconductor layer for generating electrons by being excited by light, and electrodes for collecting and discharging the generated electrons out of the photoelectric device. For example, some of the electrodes coupled to the first function layer 118 or the second function layer 128 may cross the sealing member 130 and extend to the peripheral area NP so as to be electrically connected to an external circuit.

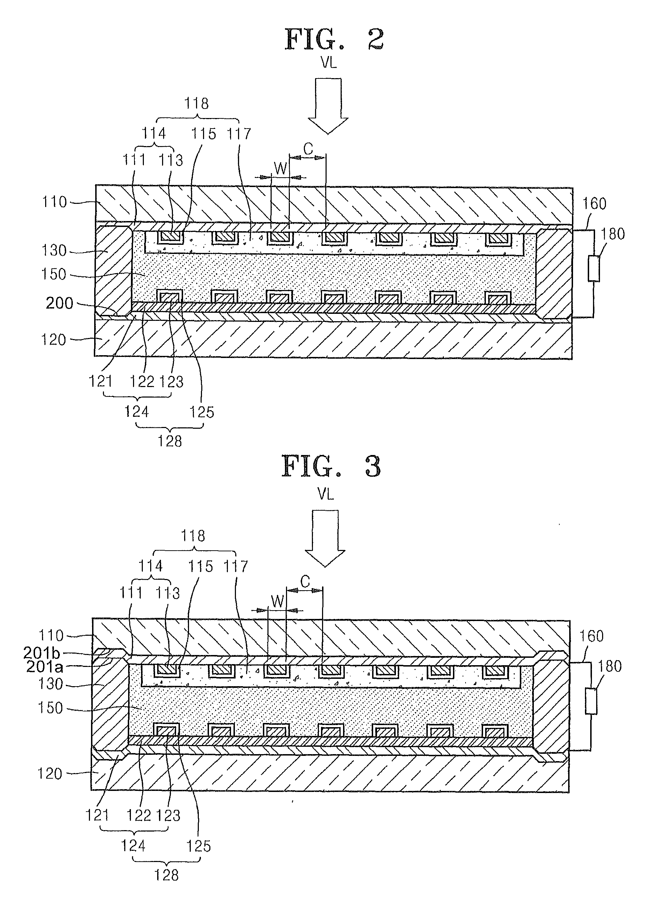

FIG. 2 is a cross-sectional view taken along a line II-II of FIG. 1, according to an embodiment of the present invention. Referring to FIG. 2, a photoelectrode 114 is formed on the light receiving substrate 110, and a counter electrode 124 is formed on the counter substrate 120 facing the photoelectrode 114. A semiconductor layer 117, on which a photosensitive dye that is excited by light VL is adsorbed, is formed on the photoelectrode 114, and an electrolyte 150 is disposed between the semiconductor layer 117 and the counter electrode 124. For example, the photoelectrode 114 and the semiconductor layer 117 are included in the function layer 118 of the light receiving substrate 110, and the counter electrode 124 is included in the function layer 128 of the counter substrate 120.

The light receiving substrate 110 and the counter substrate 120 may be attached to each other by using the sealing member 130 in such a manner that a gap is formed therebetween. The electrolyte 150 may be an electrolytic solution and may be filled between the light receiving substrate 110 and the counter substrate 120. The sealing member 130 is formed around the electrolyte 150 so as to contain the electrolyte 150, and the electrolyte 150 is sealed by the sealing member 130 so as to prevent the electrolyte 150 from leaking out of the photoelectric device.

The sealing member 130 may be formed of any of various materials having an adhesive force, for example, frit. The frit may include at least one selected from the group consisting of K₂O, Fe₂O₃, Sb₂O₃, ZnO, P₂O₅, V₂O5, TiO₂, Al₂O₃, WO₃, SnO, PbO, MgO, CaO, BaO, Li₂O, Na₂O, B₂O₃, TeO₂, SiO₂, Ru₂O, Rb₂O, Rh₂O, CuO, and Bi₂O₃.

The photoelectrode 114 and the counter electrode 124 are electrically coupled to each other through a conductive wire 160 connected to an external circuit 180. In a module in which a plurality of photoelectric devices are connected in series or in parallel, photoelectrodes and counter electrodes of the plurality of photoelectric devices may be connected in series or in parallel, and photoelectric devices on ends of the connected photoelectric devices may be connected to the external circuit 180.

The light receiving substrate 110 may be formed of a transparent material having a relatively high light transmittance. For example, the light receiving substrate 110 may be a glass substrate or a resin film substrate. Since a resin film usually has flexibility, a resin film may be applied to devices requiring flexibility.

The photoelectrode 114 may include a transparent conductive layer (first transparent conductive layer) 111 and a first grid pattern 113 formed on the transparent conductive layer 111. The transparent conductive layer 111 may be formed of a material having transparency and electrical conductivity, for example, a transparent conductive oxide (TCO) such as indium tin oxide (ITO), fluorine tin oxide (FTO), or antimony tin oxide (ATO). The first grid pattern 113 is used to reduce the electrical resistance of the photoelectrode 114, and functions as a collector wire that collects electrons generated by photoelectric conversion and provides a low resistance current path. For example, the first gird pattern 113 may be formed of a metal material having relatively high electrical conductivity, such as gold (Au), silver (Ag), or aluminium (Al), and may be patterned in a mesh fashion.

The photoelectrode 114 may function as a cathode of the photoelectric device and have a high aperture ratio. Since the light VL incident through the photoelectrode 114 excites a photosensitive dye adsorbed onto the semiconductor layer 117, the photoelectric conversion efficiency thereof may be improved when the amount of the incident light VL is increased.

A first protective layer 115 may be further formed on an outer surface of the first grid pattern 113. The first protective layer 115 prevents the first grid pattern 113 from being damaged, for example, from being eroded, when the first grid pattern 113 contacts and reacts with the electrolyte 150. The first protective layer 115 may be formed of a material that does not react with the electrolyte 150, for example, a curable resin material.

The semiconductor layer 117 may be formed of a semiconductor material that is usually used for a conventional photoelectric device, for example, a metal material such as cadmium (Cd), zinc (Zn), indium (In), lead (Pb), molybdenum (Mo), tungsten (W), antimony (Sb), titanium (Ti), silver (Ag), manganese (Mn), tin (Sn), zirconium (Zr), strontium (Sr), gallium (Ga), silicon (Si), or chromium (Cr). The semiconductor layer 117 may improve the photoelectric conversion efficiency thereof by adsorbing the photosensitive dye. For example, the semiconductor layer 117 may be formed by coating a paste of semiconductor particles having a particle diameter of about 5 nm to about 1000 nm on the light receiving substrate 110, on which the photoelectrode 114 has already been formed, and applying heat or pressure to a resultant structure.

The photosensitive dye adsorbed onto the semiconductor layer 117 may absorb the light VL passing through the light receiving substrate 110, so that electrons of the photosensitive dye may be excited from a ground state. The excited electrons may be transferred to the conduction band of the semiconductor layer 117 through electrical contact between the semiconductor layer 117 and the photosensitive dye, to the semiconductor layer 117, and to the photoelectrode 114, and are discharged out of the photoelectric device through the photoelectrode 114, thereby forming a driving current for driving the external circuit 180.

For example, the photosensitive dye adsorbed onto the semiconductor layer 117 may consist of molecules that absorb visible light VL and excite electrons so as to allow the excited electrons to be rapidly moved to the semiconductor layer 17. The photosensitive dye may be a liquid type, semi-solid gel type, or solid type photosensitive dye. For example, the photosensitive dye adsorbed onto the semiconductor layer 117 may be a ruthenium-based photosensitive dye. The semiconductor layer 117 adsorbing the photosensitive dye may be obtained by dipping the light receiving substrate 110, on which the semiconductor layer 117 has been formed, in a solution containing the photosensitive dye.

The electrolyte 150 may be formed of a redox electrolyte containing reduced/oxidized (R/O) couples. The electrolyte 150 may be formed of a solid type, gel type, or liquid type electrolyte.

The counter substrate 120 facing the light receiving substrate 110 is not necessarily transparent. However, in order to improve the photoelectric conversion efficiency, the counter substrate 120 may be formed of a transparent material so that the light VL may pass through both sides of the photoelectric device, and may be formed of the same material as that of the light receiving substrate 110. In particular, if the photoelectric device is installed as a building integrated photovoltaic (BIPV) system in a structure, e.g., a window frame, both sides of the photoelectric device may be transparent so that the light VL introduced into a building is prevented from being blocked.

The counter electrode 124 may include a transparent conductive layer (second transparent conductive layer) 121 and a catalyst layer 122 formed on the transparent conductive layer 121. The transparent conductive layer 121 may be formed of a material having transparency and electrical conductivity, for example, a TCO such as ITO, FTO, or ATO. The catalyst layer 122 may be formed of a reduction catalyzing material for providing electrons to the electrolyte 150, for example, a metal such as platinum (Pt), gold (Au), silver (Ag), copper (Cu), or aluminum (Al), a metal oxide such as tin oxide, or a carbon-based material such as graphite.

The counter electrode 124 may include a second grid pattern 123 formed on the catalyst layer 122. The second grid pattern 123 is used to reduce the electrical resistance of the counter electrode 124, and functions as a collector wire that collects electrons generated by photoelectric conversion and provides a low resistance current path. For example, the second gird pattern 123 may be formed of a metal material having relatively high electrical conductivity, such as gold (Au), silver (Ag), or aluminium (Al), and may be patterned in a mesh fashion.

A second protective layer 125 may be further formed on an outer surface of the second grid pattern 123. The second protective layer 125 prevents the second grid pattern 123 from being damaged, for example, from being eroded, when the second grid pattern 123 contacts and reacts with the electrolyte 150. The second protective layer 125 may be formed of a material that does not react with the electrolyte 150, for example, a curable resin material.

The counter electrode 124 functions as an anode of the photoelectric device, and also as a reduction catalyst for providing electrons to the electrolyte 150. The photosensitive dye adsorbed onto the semiconductor layer 117 absorbs the light VL to excite electrons, and the excited electrons are discharged out of the photoelectric device through the photoelectrode 114. The photosensitive dye losing the electrons receive electrons generated by oxidization of the electrolyte 150 to be reduced again, and the oxidized electrolyte 150 is reduced again by electrons passing through the external circuit 180 and reaching the counter electrode 124, thereby completing the operation of the photoelectric device.

In FIG. 2, a stepped portion 200 may be formed in an edge portion of the transparent conductive layer 121 formed on the counter substrate 120 or/and in an edge portion of the transparent conductive layer 111 formed on the light receiving substrate 110 in order to increase an adhesive force between the light receiving substrate 110, the counter substrate 120, and the sealing member 130. The stepped portion 200, which is shown as a groove in FIG. 2, may be formed by local heating using a laser or the like. The stepped portion 200 may be referred to as a groove.

In FIG. 2, grooves 200 are formed in edge portions of the transparent conductive layer 111 and the transparent conductive layer 121, and the sealing member 130 is filled in the grooves 200. However, the present embodiment is not limited thereto, and a groove 200 may be formed in an edge portion of either the transparent conductive layer 111 or the transparent conductive layer 121, and the sealing member 130 may be filled in the groove 200. The groove 200 may have a depth that is less than 20% of the thickness of the layer in which it is formed. For example, if the groove 200 is formed on an edge portion of the transparent conductive layer 111, the depth of the groove 200 is less than 20% of the thickness of the transparent conductive layer 111. Alternatively, the transparent conductive layers 111 and 121 may be completely removed, and the sealing member 130 may be applied between the light receiving substrate 110 and the counter substrate 120.

Since the grooves 200 are formed in the edge portions of the transparent conductive layer 111 and the transparent conductive layer 121, and the sealing member 130 is filled in the grooves 200, the adhesive force between the light receiving substrate 110, the counter substrate 120, and the sealing member 130 may be increased.

FIG. 3 is a cross-sectional view taken along the line II-II of FIG. 1, according to another embodiment of the present invention. The same explanation as for FIG. 2 will be omitted.

Referring to FIG. 3, a second stepped portion 201b is formed in an edge portion of the light receiving substrate 110 in order to increase the adhesive force between the light receiving substrate 110, the counter substrate 120, and the sealing member 130. A first stepped portion 201a is formed in an edge portion of the transparent conductive layer 111 formed on the light receiving substrate 110. The second stepped portion 201b covers the first stepped portion 201a. Another first stepped portion is formed in an edge portion of the counter substrate 120, and another second stepped portion is formed in an edge portion of the transparent conductive layer 121 formed on the counter substrate 120 as well. These stepped portions, which are referred to as grooves, may be formed by local heating using a laser or the like.

In FIG. 3, the second grooves 201b are formed in the light receiving substrate 110 and the counter substrate 120, and the first grooves 201a are formed in the transparent conductive layer 111 and the transparent conductive layer 121. The first grooves 201a are filled with the sealing member 130. However, the present embodiment is not limited thereto. The second groove 201b may be formed on an edge portion of either the light receiving substrate 110 or the counter substrate 120, and the first groove 202a may be formed in an edge portion of either the transparent conductive layer 111 or the transparent conductive layer 121. Alternatively, the second groove 201b may be formed on edge portions of both of the light receiving substrate 110 and the counter substrate 120, and the first groove 202a may be formed in edge portions of both the transparent conductive layer 111 and the transparent conductive layer 121. A groove may be formed in an edge portion of one or grooves may be formed in edge portions of both the light receiving substrate 110 and the counter substrate 120, and the sealing member 130 may be filled in the groove or grooves. Alternatively, a groove may be formed in an edge portion of one or grooves may be formed in edge portions of both the transparent conductive layer 111 and the transparent conductive layer 121, and the sealing member 130 may be filled in the groove or grooves. Alternatively, a groove may be formed in an edge portion of one or grooves may be formed in edge portions of both the light receiving substrate 110 and the transparent conductive layer 121, and the sealing member 130 may be filled in the groove or grooves. Alternatively, a groove may be formed in an edge portion of one or grooves may be formed in edge portions of both the counter substrate 120 and the transparent conductive layer 111, and the sealing member 130 may be filled in the groove or grooves.

If a groove is formed in an edge portion of one or grooves are formed in edge portions of both the light receiving substrate 110 and the counter substrate 120, the groove or grooves may have a depth that is less than 50 % of the thickness of the layer or layers in which they are formed. If a groove is formed in an edge portion of one or grooves are formed in edge portions of both the transparent conductive layer 111 and the transparent conductive layer 121, the groove or grooves may have a depth that is less than 20 % of the thickness of the layer or layers in which they are formed. Alternatively, at least one of the transparent conductive layers 111 and 121 may be completely removed, and the sealing member 130 may be applied between the light receiving substrate 110 and the counter substrate 120. If a groove is formed in an edge portion of one or grooves are formed in edge portions of both the light receiving substrate 110 and the transparent conductive layer 121, or if a groove is formed in an edge portion of one or grooves are formed in edge portions of both the counter substrate 120 and the transparent conductive layer 111, the groove or grooves may have a depth that is less than 50 % of the thickness of the layer or layers in which they are formed, may be less than 20 % of the thickness of the layer in which they are formed, or may be 100 % of the thickness of the layer or layers in which they are formed.

Since the grooves are formed in the edge portions of the light receiving substrate 110 and/or the counter substrate 120, and/or the transparent conductive layer 111, and/or the transparent conductive layer 121, and the sealing member 130 is filled in the grooves, the adhesive force between the light receiving substrate 110, the counter substrate 120, and the sealing member 130 may be increased.

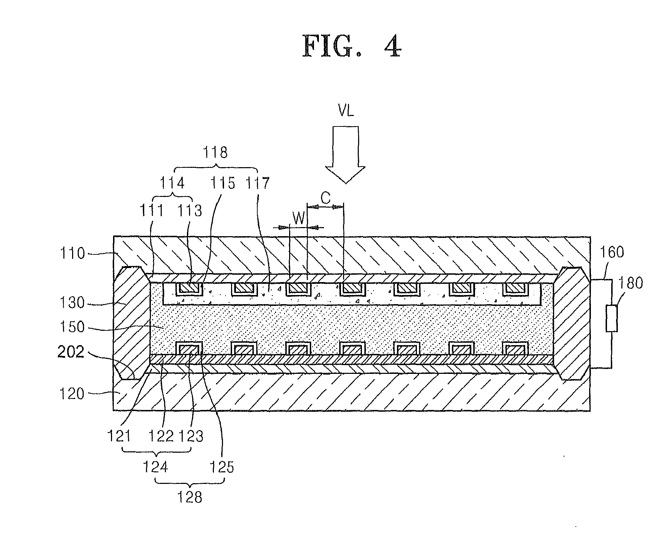

FIG. 4 is a cross-sectional view taken along the line II-II of FIG. 1, according to another embodiment of the present invention. Explanations that are the same explanations as with regards to FIG. 2 will be omitted.

Referring to FIG. 4, a stepped portion 202 is formed in an edge portion of the light receiving substrate 110 and/or a stepped portion 202 is formed in an edge portion of the counter substrate 120 in order to increase the adhesive force between the light receiving substrate 110, the counter substrate 120, and the sealing member 130. The stepped portion 202, which is referred to as a groove, may be formed by local heating using a laser or the like.

In FIG. 4, grooves 202 are formed in the light receiving substrate 110 and the counter substrate 120, and the grooves 202 are filled with the sealing member 130. However, the present embodiment is not limited thereto, and a groove may be formed in an edge portion of one or grooves may be formed in edge portions of both the light receiving substrate 110 and the counter substrate 120, and the sealing member 130 may be filled in the groove or grooves. If a groove is formed in an edge portion of one or grooves are formed in edge portions of both the light receiving substrate 110 and the counter substrate 120, the groove may have a depth that is less than 50 % of the thickness of the layer or layers in which the grooves are formed.

Since the grooves are formed in the edge portions of the light receiving substrate 110 and/or the counter substrate 120, and the sealing member 130 is filled in the grooves, the adhesive force between the light receiving substrate 110, the counter substrate 120, and the sealing member 130 may be increased.

While the one or more embodiments of the present invention have been particularly shown and described, it will be understood by those of ordinary skill in the art that various changes in form and detail may be made therein without departing from the scope of the invention as defined by the following claims.

## Claims

1. A photoelectric device comprising:
a first substrate (110);
a second substrate (120) facing the first substrate;
a photoelectrode (114) formed on a surface of the first substrate facing the second substrate;
a counter electrode (124) formed on a surface of the second substrate facing the first substrate;
a semiconductor layer (117) formed on the photoelectrode, the semiconductor layer including a photosensitive dye that generates electrons when excited by light;
an electrolyte (150) disposed between the semiconductor layer and the counter electrode; and
a sealing member (130) for sealing the photoelectric device, the sealing member being arranged at a stepped portion (200, 201a, 201b, 202) of the photoelectric device, wherein the stepped portion is formed in one or both of the first and second substrates (110, 120) and/or in a transparent conductive layer (111, 121) formed on one or both of the first and second substrates.

2. The photoelectric device of claim 1, wherein the stepped portion is formed by local heating using a laser.

3. The photoelectric device of claim 1 or 2, wherein the stepped portion is formed in an edge portion of one or both of the first and second substrates and/or the transparent conductive layer formed on one or both of the first and second substrates.

4. The photoelectric device of any one of claims 1 to 3, wherein the depth of the stepped portion in one or both of the first and second substrates is less than 50 % of the thickness of the first or the second substrate.

5. The photoelectric device of any one of the preceding claims, wherein the stepped portion formed in the transparent conductive layer formed on one or both of the first and second substrates comprises a first stepped portion formed in an edge portion thereof.

6. The photoelectric device of claim 5, wherein the depth of the first stepped portion is less than 20 % of the thickness of the first or the second transparent conductive layer.

7. The photoelectric device of claim 5, wherein the depth of the first stepped portion is 100 % of the thickness of the first or the second transparent conductive layer.

8. The photoelectric device of claim 1, comprising a first transparent layer (111) on the first substrate (110) and a second transparent layer (121) on the second substrate (120), each of the first and second transparent layers including a first stepped portion (200, 201a) wherein the sealing member (130) is arranged at the stepped portions between the first and second transparent layers.

9. The photoelectric device of claim 8, wherein the first and second substrates (110, 120) each include a second stepped portion (201b), wherein the first and second transparent layers are disposed in the second stepped portions (201b) to form the first stepped portion (201a).

10. The photoelectric device of claim 1, wherein the first and second substrates each comprise a stepped portion (202) and the sealing member (130) is disposed in the stepped portion.

11. The photoelectric device of claim 10, further comprising first and second transparent layers (111, 121) disposed on the first and second substrates and extending between portions of the sealing member (130) at opposite ends of the substrate.
